# EUROPEAN PATENT APPLICATION

(11) **EP 1 892 752 A1**
(43) Date of publication of application: **27.02.2008**
(21) Application number: 06746591.4
(22) Date of filing: 18.05.2006
(51) Int. Cl.: H01L 21/285, C23C 16/34, C23C 16/52, H01L 21/28, H01L 21/768, H01L 21/8242, H01L 27/108

(54) **METHOD OF FILM FORMATION AND COMPUTER-READABLE STORAGE MEDIUM**

(30) Priority: 23.05.2005 JP 2005150186
(71) Applicant: TOKYO ELECTRON LIMITED, Minato-ku Tokyo 107-8481 (JP)
(72) Inventor: HASEGAWA, Toshio c/o Tokyo Electron At Limited, Nirasaki-shi, Yamanashi40 70192 (JP)
(74) Representative: HOFFMANN EITLE
(86) International application number: PCT/JP2006/309903
(87) International publication number: WO 2006/126440

(57) **Abstract**

A film formation method includes a first stage including a period of heating a target substrate to a film formation temperature, and supplying a metal compound gas and a nitrogen-containing reducing gas onto the target substrate, thereby directly depositing a metal nitride film by CVD on a target substrate; and a second stage of supplying the metal compound gas and the nitrogen-containing reducing gas, thereby further depositing a metal nitride film by CVD on the metal nitride film initially deposited by the first stage, to obtain a predetermined film thickness. Each of the first stage and the second stage is arranged to repeat one or more times a cycle including a first step of supplying the metal compound gas and the nitrogen-containing reducing gas and a second step of stopping the metal compound gas and supplying the nitrogen-containing reducing gas.

## Description

### Technical Field

The present invention relates to a film formation method by CVD, and more specifically to a film formation method for forming a metal nitride film, such as a TiN family thin film, used as, e.g., a barrier layer, capacitor upper electrode, gate electrode, or contact portion in semiconductor devices. The present invention further relates to a computer readable storage medium for executing a method of this kind.

### Background Art

In recent years, multi-layered interconnection structures are being increasingly used for circuitry, because higher density and higher integration degree are required in manufacturing semiconductor devices. Under the circumstances, embedding techniques for electrical connection between layers have become important, e.g., at contact holes used as connections between an underlying semiconductor device and upper interconnection layers, and at via-holes used as connections between upper and lower interconnection layers. Further, in order to meat high dielectric constant materials, such as Ta₂O₅ and HfO₂, used as capacitor materials in, e.g., DRAM memory sections, techniques for forming an upper electrode thereon with higher coverage have also become important, along with the increase in integration degree.

Further, in recent years, TiN films are used as barrier layers for metal embedded in contact holes and via-holes, and as upper electrodes in capacitors, as described above.

Conventionally, PVD is utilized in methods for forming TiN films of this kind. However, in recent years, along with the increase in miniaturization and integration degree of devices, CVD is frequently utilized, because CVD can be expected to provide a film with better quality and higher coverage.

Where a TiN film is formed by CVD, film formation is performed at a temperature of 500 to 600°C while TiCl₄ used as a reactive gas and NH₃ or MMH (monomethylhydrazine) used as a nitrogen-containing reducing gas are supplied.

However, high dielectric constant materials, such as Ta₂O₅ and HfO₂, are sensitive to temperature. Where a TiN film is formed thereon as an upper electrode, it is necessary to perform the film formation at a low temperature of less than 500°C so as to prevent the underlayer from suffering thermal damage.

Further, there is a case where NiSi is used as a contact material, although NiSi is low in heat resistance. Accordingly, where a metal nitride film is formed on an NiSi underlayer, it is preferable to perform the film formation at a lower temperature.

However, where a TiN film is formed by CVD at a low temperature of less than 500°C, it is difficult to sufficiently remove Cl, resulting in a high resistivity.

As a technique for improving such film formation performed at a low temperature, the following technique has been proposed (Patent Document 1). Specifically, this technique is arranged to alternately repeat a step of supplying both of TiCl₄ gas used as a source gas and NH₃ gas used as a reducing gas to perform film formation and a step of solely supplying NH₃ gas used as a reducing gas to perform a reduction reaction. Patent Document 1 describes that this technique can realize film formation at a low temperature of about 450°C, and can provide a film of high quality with decreased Cl residues.

However, in recent years, demands on the quality of TiN films and so forth are increasing stricter, so films are considered as being inferior if they have a slight amount of abnormality, such as abnormal growth, in appearance. In this respect, the technique disclosed in Patent Document 1 cannot completely exclude abnormal growth at a temperature of less than 500°C, such as 450°C. Further, in recent years, film formation is required to be performed at a lower temperature of less than 450°C, such as 400°C. In this respect, the technique disclosed in Patent Document 1 cannot be applied to film formation performed at such a lower temperature, because the resistivity of films is increased.
Patent Document 1: Jpn. Pat. Appln. KOKAI Publication No. 2003-77864

### Disclosure of Invention

An object of the present invention is to provide a film formation method which allows a metal nitride film to be formed with high quality and without abnormal growth by CVD at a low film formation temperature of less than 500°C, and further of less than 450°C.
Another object of the present invention is to provide a computer readable storage medium for executing a method of this kind.

According to a first aspect of the present invention, there is provided a film formation method comprising: a first stage including a period of heating a target substrate to a film formation temperature, and supplying a metal compound gas and a nitrogen-containing reducing gas onto the target substrate, thereby directly depositing a metal nitride film by CVD on a target substrate; a second stage of supplying the metal compound gas and the nitrogen-containing reducing gas, thereby further depositing a metal nitride film by CVD on the metal nitride film initially deposited by the first stage, to obtain a predetermined film thickness, wherein the first stage is performed under conditions that cause uniform reduction of the metal compound gas to prevent a metal nitride film from being locally deposited.

According to a second aspect of the present invention, there is provided a film formation method comprising: a first stage including a period of heating a target substrate to a film formation temperature, and supplying a metal compound gas and a nitrogen-containing reducing gas onto the target substrate, thereby directly depositing a metal nitride film by CVD on a target substrate; a second stage of supplying the metal compound gas and the nitrogen-containing reducing gas, thereby further depositing a metal nitride film by CVD on the metal nitride film initially deposited by the first stage, to obtain a predetermined film thickness, wherein each of the first stage and the second stage is arranged to repeat one or more times a cycle comprising a first step of supplying the metal compound gas and the nitrogen-containing reducing gas and a second step of stopping the metal compound gas and supplying the nitrogen-containing reducing gas.

According to a third aspect of the present invention, there is provided a computer readable storage medium that stores a control program for execution on a computer, wherein the control program, when executed by the computer, controls a film formation apparatus to conduct a film formation method comprising: a first stage including a period of heating a target substrate to a film formation temperature, and supplying a metal compound gas and a nitrogen-containing reducing gas onto the target substrate, thereby directly depositing a metal nitride film by CVD on a target substrate; a second stage of supplying the metal compound gas and the nitrogen-containing reducing gas, thereby further depositing a metal nitride film by CVD on the metal nitride film initially deposited by the first stage, to obtain a predetermined film thickness, wherein the first stage is performed under conditions that cause uniform reduction of the metal compound gas to prevent a metal nitride film from being locally deposited.

According to a fourth aspect of the present invention, there is provided a computer readable storage medium that stores a control program for execution on a computer, wherein the control program, when executed by the computer, controls a film formation apparatus to conduct a film formation method comprising: a first stage including a period of heating a target substrate to a film formation temperature, and supplying a metal compound gas and a nitrogen-containing reducing gas onto the target substrate, thereby directly depositing a metal nitride film by CVD on a target substrate; a second stage of supplying the metal compound gas and the nitrogen-containing reducing gas, thereby further depositing a metal nitride film by CVD on the metal nitride film initially deposited by the first stage, to obtain a predetermined film thickness, wherein each of the first stage and the second stage is arranged to repeat one or more times a cycle comprising a first step of supplying the metal compound gas and the nitrogen-containing reducing gas and a second step of stopping the metal compound gas and supplying the nitrogen-containing reducing gas.

In the first aspect, the first stage may be arranged to repeat one or more times a cycle comprising a first step of supplying the metal compound gas and the nitrogen-containing reducing gas and a second step of stopping the metal compound gas and supplying the nitrogen-containing reducing gas. In this case, the first stage is preferably arranged such that a flow rate of the nitrogen-containing reducing gas in the second step is not smaller than a flow rate of the nitrogen-containing reducing gas in the first step.

The metal nitride film may be a TiN film. In this case, the metal compound gas may be TiCl₄ gas, and the nitrogen-containing reducing gas may be NH₃ gas. Where these gases are used, the first stage is preferably arranged such that a flow rate of NH₃ gas in the second step is not smaller than a flow rate of NH₃ gas in the first step. In this case, the flow rate of NH₃ gas in the second step is preferably set at 500 mL/min or more. The second step is preferably performed for a time of 2 seconds or more.

The first aspect is effective where the film formation temperature of the target substrate is set to be less than 500°C, and particularly to be less than 450°C. The second stage is preferably arranged to repeat one or more times a cycle comprising a first step of supplying the metal compound gas and the nitrogen-containing reducing gas and a second step of stopping the metal compound gas and supplying the nitrogen-containing reducing gas. The first stage may be arranged to repeat one or more times a cycle comprising a third step of supplying the metal compound gas and a fourth step of supplying the nitrogen-containing reducing gas.

In the second aspect, the first stage and the second stage may be arranged to use the same conditions in the first step and the same conditions in the second step. The first step of the first stage may be performed for a time shorter than that of the first step of the second stage. The second step of the first stage may be performed for a time longer than that of the second step of the second stage. In this case, a flow rate of the nitrogen-containing reducing gas in the second step is preferably not smaller than a flow rate of the nitrogen-containing reducing gas in the first step.

In each of the first and second aspects, the metal nitride film may be a TiN film. In this case, the metal compound gas is preferably TiCl₄ gas, and the nitrogen-containing reducing gas is preferably NH₃ gas. Where these gases are used, a flow rate of NH₃ gas in the second step is preferably not smaller than a flow rate of NH₃ gas in the first step. In this case, the flow rate of NH₃ gas in the second step is preferably set at 500 mL/min or more. The second step is preferably performed for a time of 2 seconds or more.

The second aspect is effective where the film formation temperature of the target substrate is set to be less than 500°C, and particularly to be less than 450°C. In this case, the cycle comprising the first step and the second step is preferably performed under conditions that cause the second stage to provide a thickness of 1 nm or less.

According to the present invention, the first stage at the beginning of film formation is performed under conditions that cause uniform reduction of the metal compound gas to prevent a metal nitride film from being locally deposited, in place of the conventional incubation time. Consequently, even where the film formation is performed at a low temperature of less than 500°C, which causes the first stage at the beginning of film formation to have a low film formation rate, a metal nitride film can be formed with high quality and without abnormal growth. Specifically, the first stage may be arranged to repeat one or more times a cycle comprising a first step of supplying the metal compound gas and the nitrogen-containing reducing gas and a second step of stopping the metal compound gas and supplying the nitrogen-containing reducing gas. In this case, reduction of the metal compound gas is sufficiently and uniformly performed to prevent a metal nitride film from being locally deposited, so that a metal nitride film can be formed with high quality and without abnormal growth.

### Brief Description of Drawings

[FIG. 1] This is a structural view schematically showing an example of a film formation apparatus used for performing a film formation method according to the present invention.
[FIG. 2] This is a view for explaining a sequence including a conventional additional time (incubation time).
[FIG. 3] This is a graph showing the relationship between the total film formation time and film thickness in the sequence including the conventional incubation time.
[FIG. 4] This is a view showing a model for explaining a film formation state of a first stage in a case where the incubation time is used along with a film formation temperature of 400°C.
[FIG. 5] This is a view schematically showing an example of a sequence of a film formation method according to the present invention.
[FIG. 6] This is a view showing a model for explaining a film formation state of a first stage in a case where the sequence shown in FIG. 5 is used along with a film formation temperature of 400°C.
[FIG. 7] This is a timing chart showing the gas supply sequence of a film formation method according to an embodiment of the present invention.
[FIG. 8] This is a graph showing the relationship of the NH₃ gas post-flow time of one cycle, which is denoted by the horizontal axis, relative to the resistivity and throughput of a TiN film, which are denoted by the vertical axes, obtained at a film formation temperature (wafer temperature) of 400°C.
[FIG. 9A] This is a view of a scanning electron microscope (SEM) photography showing a surface state of a TiN film, in a case having an NH₃ post-flow set at 5 seconds.
[FIG. 9B] This is a view of a scanning electron microscope (SEM) photography showing a surface state of a TiN film, in a case having an NH₃ post-flow set at 10 seconds.
[FIG. 10] This is a timing chart showing an example of an actual sequence for TiN film formation performed at a film formation temperature (wafer temperature) of 400°C.
[FIG. 11] This is a view of a transmission electron microscopy (TEM) photography showing a cross section of a TiN film formed by the sequence shown in FIG. 10.
[FIG. 12] This is a view of a transmission electron microscopy (TEM) photography showing a cross section of a TiN film formed by a sequence obtained by replacing the first stage of the sequence shown in FIG. 10 with an incubation time of 23 seconds.
[FIG. 13] This is a sectional view showing an example where a TiN thin film formed by a film formation method according to the present invention is applied to a capacitor structure, such as a DRAM.
[FIG. 14] This is a sectional view showing an alternative example where a TiN thin film formed by a film formation method according to the present invention is applied to a capacitor structure, such as a DRAM.
[FIG. 15] This is a sectional view showing another alternative example where a TiN thin film formed by a film formation method according to the present invention is applied to a capacitor structure, such as a DRAM.
[FIG. 16] This is a sectional view showing an example where a TiN thin film formed by a film formation method according to the present invention is applied to a contact portion of a metal interconnection layer.

### Best Mode for Carrying Out the Invention

An embodiment of the present invention will now be described with reference to the accompanying drawings.
In the embodiment, an explanation will be given of a case where TiCl₄ gas is used as a metal compound gas and NH₃ gas is used as a nitrogen-containing reducing gas to form a thin film of titanium nitride (TiN) by thermal CVD.

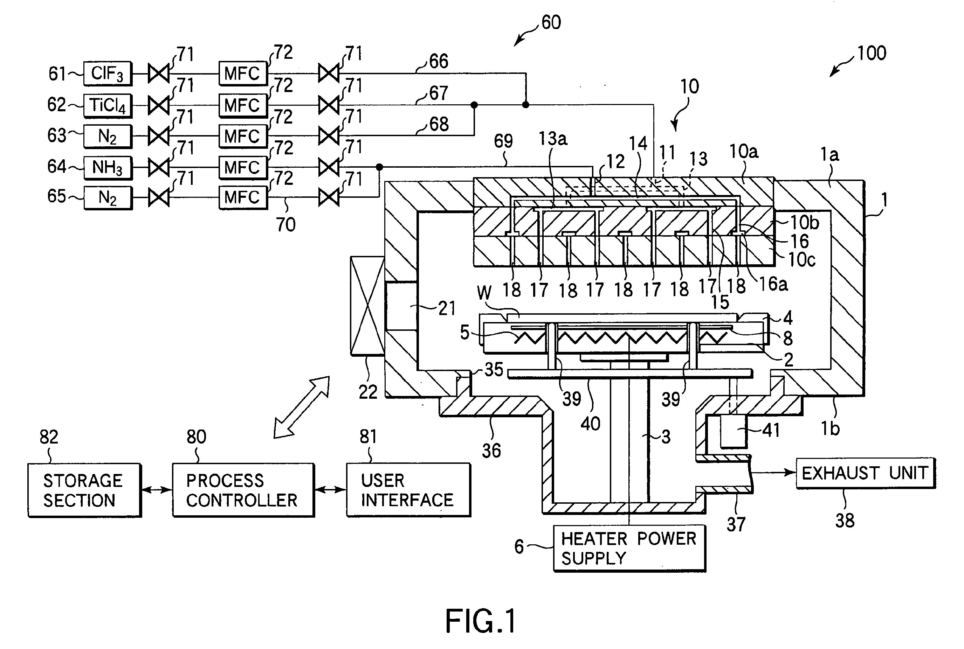

FIG. 1 is a structural view schematically showing an example of a film formation apparatus used for performing a film formation method according to the present invention.

The film formation apparatus 100 includes an essentially cylindrical airtight chamber 1. The chamber 1 is provided with a susceptor 2 disposed therein for supporting a target substrate or wafer W in a horizontal state. The susceptor 2 is supported by a cylindrical support member 3 disposed therebelow at the center. The susceptor 2 is made of a ceramic, such as AlN, and has a guide ring 4 disposed on the edge to guide the wafer W. The susceptor 2 is provided with a heater 5 built therein. The heater 5 is supplied with a power from a power supply 6 to heat the target substrate or wafer W to a predetermined temperature. Further, the susceptor 2 is provided with an electrode 8 built therein above the heater 5 and used as a lower electrode.

The chamber 1 has a transfer port 21 formed in the sidewall and provided with a gate valve 22. The wafer W is transferred by a wafer transfer unit (not shown) between the susceptor 2 and an external wafer transfer chamber (not shown) held in a vacuum state, through the gate valve 22.

The susceptor 2 is provided with a plurality of lifter pins 39 that penetrate a mount region for placing the wafer W thereon. The lifter pins 39 are used for moving the wafer W up and down when the wafer W is transferred between the wafer transfer unit (not shown) and the mount region. The lifter pins 39 are driven up and down by an elevating mechanism 41 through a driving arm 40.

The bottom of the chamber 1 is provided with an exhaust chamber 36 connected to an exhaust unit 38 through an exhaust line 37. The exhaust unit 38 can be operated to uniformly exhaust the chamber 1 and to decrease the inner pressure thereof to a predetermined vacuum level.

A showerhead 10 is disposed on the ceiling wall 1a of the chamber 1. The showerhead 10 is formed of an upper block body 10a, a middle block body 10b, and a lower block body 10c.

Feed holes 17 and 18 for feeding gases are alternately formed in the lower block body 10c. On the other hand, a first gas feed port 11 and a second gas feed port 12 are formed in the upper surface of the upper block body 10a. The first gas feed port 11 is divided into a number of gas passages 13 in the upper block body 10a. The middle block body 10b has gas passages 15 formed therein, which communicate with the gas passages 13 through communication passages 13a extending horizontally. The gas passages 15 communicate with the feed holes 17 formed in the lower block body 10c. The second gas feed port 12 is divided into a number of gas passages 14 in the upper block body 10a. The middle block body 10b has gas passages 16 formed therein, which communicate with the gas passages 14. The gas passages 16 are connected to communication passages 16a extending horizontally in the middle block body 10b. The communication passages 16a communicate with a number of feed holes 18 formed in the lower block body 10c. The first and second gas feed ports 11 and 12 are respectively connected to a gas supply mechanism 60 described later.

The gas supply mechanism 60 includes a ClF₃ gas supply source 61 for supplying ClF₃ gas used as a cleaning gas, a TiCl₄ gas supply source 62 for supplying TiCl₄ gas used as a Ti-containing gas, a first N₂ gas supply source 63 for supplying N₂ gas, an NH₃ gas supply source 64 for supplying NH₃ gas used as a nitriding gas, and a second N₂ gas supply source 65 for supplying N₂ gas. The ClF₃ gas supply source 61 is connected to a ClF₃ gas supply line 66, the TiCl₄ gas supply source 62 is connected to a TiCl₄ gas supply line 67, the first N₂ gas supply source 63 is connected to a first N₂ gas supply line 68, the NH₃ gas supply source 64 is connected to an NH₃ gas supply line 69, and the second N₂ gas supply source 65 is connected to a second N₂ gas supply line 70. Further, the gas supply mechanism 60 includes an Ar gas supply source (not shown). Each of the gas supply lines is provided with a mass-flow controller 72 and two valves 71 one on either side of the controller 72.

The first gas feed port 11 of the showerhead 10 is connected to the TiCl₄ gas supply line 67 extending from the TiCl₄ gas supply source 62. The TiCl₄ gas supply line 67 is connected to the ClF₃ gas supply line 66 extending from the ClF₃ gas supply source 61, and is also connected to the first N₂ gas supply line 68 extending from the first N₂ gas supply source 63. The second gas feed port 12 is connected to the NH₃ gas supply line 69 extending from the NH₃ gas supply source 64. The NH₃ gas supply line 69 is connected to the second N₂ gas supply line 70 extending from the gas supply source 65.

According to this arrangement, when a process is performed, TiCl₄ gas from the TiCl₄ gas supply source 62 and N₂ gas from the first N₂ gas supply source 63 are supplied into the TiCl₄ gas supply line 67. This mixture gas flows through the first gas feed port 11 into the showerhead 10, and is then guided through the gas passages 13 and 15 and fed into the chamber 1 through the feed holes 17. On the other hand, NH₃ gas used as a nitrogen-containing reducing gas from the NH₃ gas supply source 64 and N₂ gas from the second N₂ gas supply source 65 are supplied into the NH₃ gas supply line 69. This mixture gas flows through the second gas feed port 12 into the showerhead 10, and is then guided through the gas passages 14 and 16 and fed into the chamber 1 through the feed holes 18.

In other words, the showerhead 10 is of a post-mix type in which TiCl₄ gas and NH₃ gas are supplied into the chamber 1 separately from each other. TiCl₄ gas and NH₃ gas react with each other by thermal energy after they are fed and mixed.

The respective components of the film formation apparatus 100 are connected to and controlled by a process controller 80. The process controller 80 is connected to a user interface 81 including, e.g. a keyboard and a display, wherein the keyboard is used for a process operator to input commands for operating the film formation apparatus 100, and the display is used for showing visualized images of the operational status of the plasma processing apparatus 100.

Further, the process controller 80 is connected to a storage section 82 that stores control programs for the process controller 80 to control the film formation apparatus 100 so as to perform various processes, and programs or recipes for respective components of the film formation apparatus 100 to perform processes in accordance with process conditions. Recipes may be stored in a hard disk or semiconductor memory, or stored in a portable storage medium, such as a CDROM or DVD, to be attached to a predetermined position in the storage section 82. Further, recipes may be transmitted from another apparatus through, e.g., a dedicated line, as needed.

A required recipe is retrieved from the storage section 82 and executed by the process controller 80 in accordance with an instruction or the like through the user interface 81. As a consequence, the film formation apparatus 100 can perform a predetermined process under the control of the process controller 80.

Next, an explanation will be given of a film formation method according to an embodiment performed in this apparatus.
At first, the interior of the chamber 1 is exhausted by the exhaust unit 38 at full throttle, and N₂ gas is supplied from the first and second gas supply sources 63 and 65 through the showerhead 10 into the chamber 1. In this state, the interior of the chamber 1 is pre-heated by the heater 5. When the temperature becomes stable, N₂ gas, NH₃ gas, and TiCl₄ gas are supplied respectively from the first N₂ gas supply source 63, NH₃ gas supply source 64, and TiCl₄ gas supply source 62 through the showerhead 10 into the chamber 1 at predetermined flow rates, while the pressure inside the chamber 1 is maintained at a predetermined value. The TiCl₄ gas is caused to flow through a pre-flow line (not shown) to stabilize the flow rate. By doing so, a TiN pre-coating film is formed by use of heat from the heater 5 on the surface of the members within the chamber 1, such as the inner wall of the chamber 1, susceptor 2, guide ring 4, and showerhead 10.

When the pre-coating process is finished, the NH₃ gas and TiCl₄ gas are stopped, and N2 gas is supplied as a purge gas from the first and second N₂ gas supply sources 63 and 65 into the chamber 1 to purge the interior of the chamber 1. Then, as needed, N₂ gas and NH₃ gas are supplied to perform a nitridation process on the surface of the TiN pre-coating film, so as to stabilize the pre-coating film.

Thereafter, the interior of the chamber 1 is rapidly vacuum-exhausted by the exhaust unit 38 at full throttle. In this state, the gate valve 22 is opened, and a wafer W is transferred through the transfer port 21 into the chamber 1. Then, N₂ gas is supplied into the chamber 1 and the wafer W is pre-heated. When the wafer temperature becomes essentially stable at a film formation temperature, TiN film formation is started.

In this TiN film formation, reduction and nitridation of TiCl₄ gas used as a source gas are performed by NH₃ gas used as a reducing gas as well as a nitriding gas in a heating atmosphere, so that TiN is deposited on the underlayer. This process includes a first stage having a very low deposition rate as an initial phase of the TiN film formation, and a second stage showing steady progress of deposition of the TiN film thereafter.

The stage having a low deposition rate appears as an initial phase of the TiN film formation, because of the following reason. Specifically, in the initial phase, an adsorption reaction of TiCl₄ gas and NH₃ gas onto the underlayer is dominant. However, at this time, since part of adsorbed substances is desorbed due to a low adsorption force, the supplied gases can only partly contribute to the film formation.

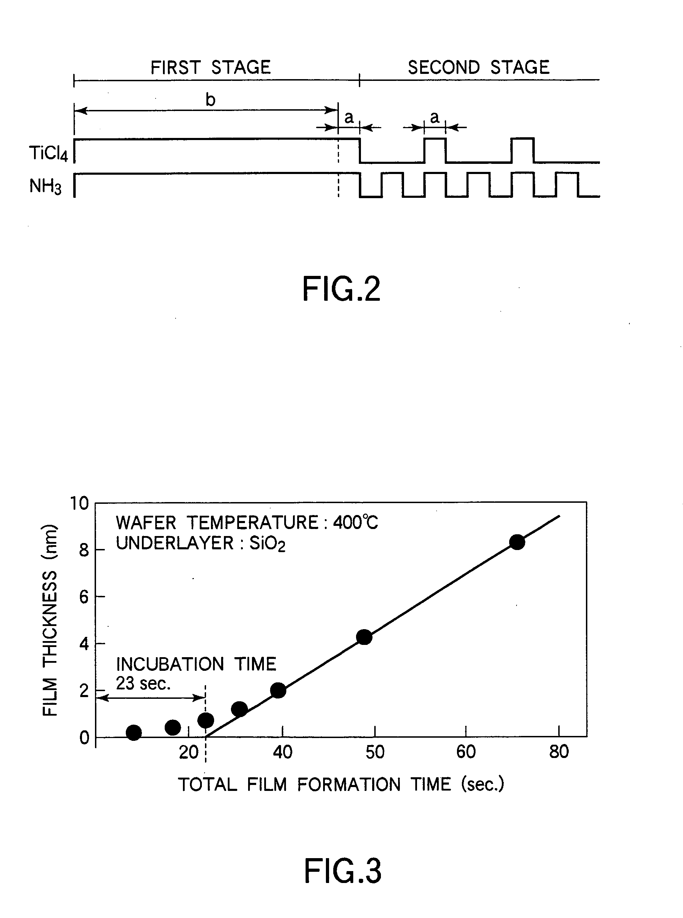

As described above, Patent Document 1 discloses a technique for forming a TiN film at a low temperature, which is arranged to alternately repeat a film formation step of supplying both of TiCl₄ gas and NH₃ gas and a reduction step of solely supplying NH₃ gas. In actual processes according to this technique, the time of the film formation step is set to provide a constant film thickness deposited in one cycle. Accordingly, the first film formation step corresponding to the first stage having a low film formation rate needs to be prolonged by that much for the low film formation rate. Specifically, as shown in FIG. 2, the first film formation step needs to include a predetermined additional time (incubation time) "b" in addition to the time "a" of the film formation step of the second stage.

The incubation time becomes longer with a decrease in the film formation temperature. For example, it is assumed that the flow rates of TiCl₄ gas and NH₃ gas are set at the same value of 30 mL/min, and a TiN film having a thickness of 0.5 nm is deposited on an SiO₂ underlayer in one cycle of one film formation step for 4 seconds under the steady state of the second stage. In this case, as shown in FIG. 3, the incubation time necessary for forming a first layer film of 0.5 nm in the first film formation step is 3.2 seconds at a film formation temperature of 600°C, 4.2 seconds at 550°C, and 7.5 seconds at 500°C. This necessary incubation time is increased to be 10.5 seconds at 450°C, and further to a very large value of 23 seconds at 400°C. The film formation rate thus obtained is too low to form a first layer film of 0.5 nm in the first film formation step.

According to an experimental result obtained by the present inventors, it has been confirmed that, where an incubation time is added to the first stage, an abnormal growth remains in a case with a film formation temperature (wafer temperature) of less than 500°C even if the number of cycles is increased. Accordingly, the present inventors have thought that a long incubation time as described above is a cause for the abnormal growth in TiN film formation at a film formation temperature of less than 500°C, and particularly of less than 450°C.

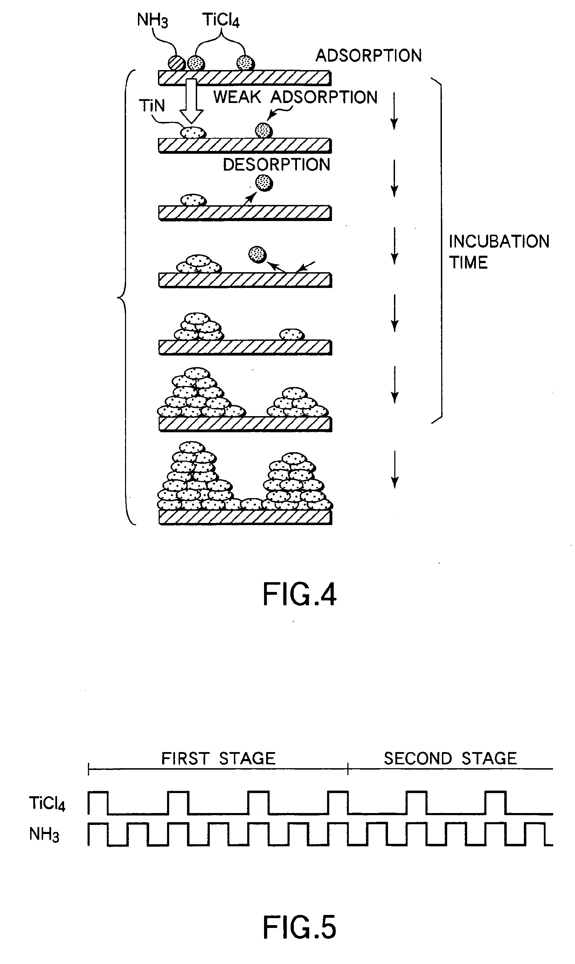

Specifically, in the incubation time, as shown in the model of FIG. 4, when the TiCl₄ gas and NH₃ gas are supplied at flow rates equal to each other and NH₃ are TiCl₄ reach the underlayer at first, NH₃ is not necessarily present on a part which TiCl₄ arrives at. When TiCl₄ reaches a part with NH₃ present thereon, TiN is deposited on the underlayer. However, when TiCl₄ is adsorbed on a part with no NH₃ present thereon, TiCl₄ is provided with only a low adsorption force and thus is easily desorbed, whereby TiN can be hardly deposited on this part. In this state, TiCl₄ gas and NH₃ gas are kept supplied, so TiN is deposited and rapidly grown on a part of the underlayer with TiN having been deposited, while TiN is deposited very slowly on a part with no TiN having been deposited. Local growth thus caused during the incubation time brings about an abnormal growth in the film formation process. It means that, since NH₃ gas used as a reducing gas is not sufficiently supplied all over the underlayer during the first stage at the beginning of film formation, a reduction reaction is locally caused.

In light of this, according to this embodiment, the first stage at the beginning of film formation is arranged such that NH₃ gas is sufficiently supplied relative to TiCl₄ gas, so that TiN uniformly is grown all over the underlayer. For this purpose, as shown in FIG. 5, in place of using the incubation time, the first stage at the beginning of film formation may be arranged to alternately repeat a step of supplying both of TiCl₄ gas and NH₃ gas and a step of solely supplying NH₃ gas, as in the second stage. This arrangement enhances the reduction action of NH₃ gas to a great extent, so that a TiN film is formed with high quality and without abnormal growth.

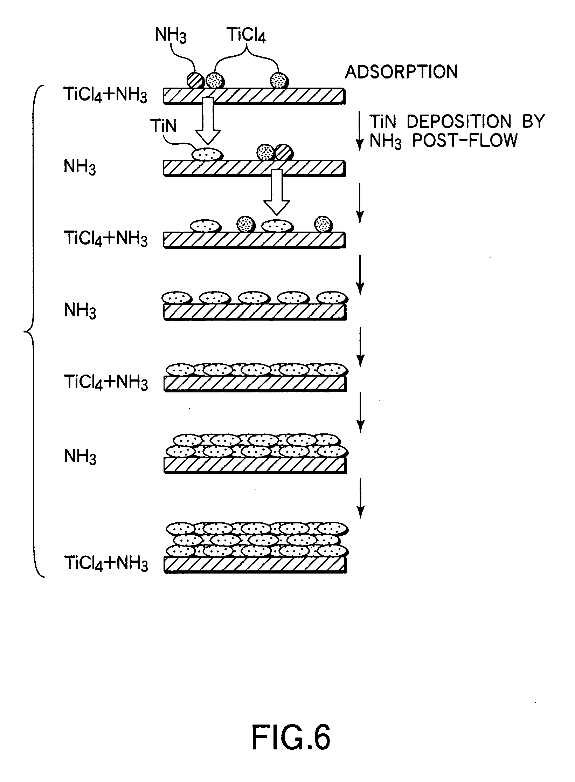

This effect will be explained in detail with reference to the model shown in FIG. 6. When TiCl₄ gas and NH₃ gas are first supplied and NH₃ and TiCl₄ reach the underlayer, TiN is deposited on the underlayer where TiCl₄ reaches a part with NH₃ present thereon. Non-reacted TiCl₄ adsorbed on the underlayer is subjected to reduction by the subsequent post-flow of NH₃ gas, so that TiN is deposited on the underlayer. Specifically, after TiCl₄ gas and NH₃ gas are supplied in a short time, NH₃ gas post-flow is performed, so that reduction and nitridation of TiCl₄ are sufficiently performed, thereby preventing local deposition of TiN. Where repeating the step of supplying TiCl₄ gas and NH₃ gas, and the step of performing NH₃ gas post-flow, TiN is uniformly deposited. Consequently, TiN is uniformly deposited also in the subsequent second stage, so that a TiN film is formed with high quality and without abnormal growth, even by film formation performed at a low temperature of less than 500°C, such as 400°C.

In this case, in order to sufficiently perform reduction and nitridation of TiCl₄, the flow rate of NH₃ gas in the post-flow is preferably set to be larger than the flow rate of NH₃ gas in the film formation.

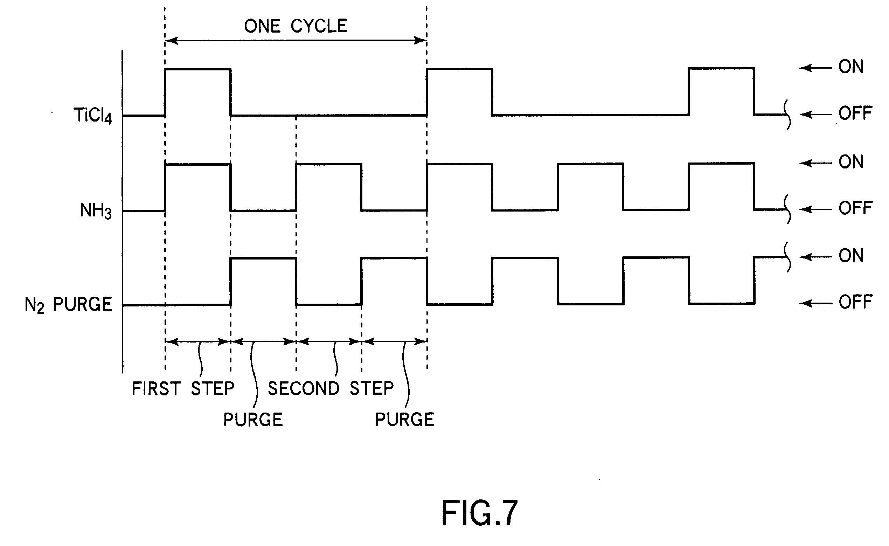

Next, a detailed explanation will be given of film formation conditions according to this embodiment.
In this embodiment, gas flows are alternated to form a TiN film in both of the first stage at the beginning of film formation and the subsequent second stage. Specifically, as shown in the timing chart of FIG. 7, at first, a first step is performed such that TiCl₄ gas and NH₃ gas are supplied from the TiCl₄ gas supply source 62 and NH₃ gas supply source 64 and are carried by N₂ gas from the first and second N₂ gas supply sources 63 and 65 into the chamber 1 to deposit TiN by thermal CVD. Then, TiCl₄ gas and NH₃ gas are stopped, and N₂ gas is supplied into the chamber 1 to purge the interior of the chamber 1. Then, a second step is performed such that NH₃ gas is supplied from the NH₃ gas supply source 64 and is carried by N₂ gas from the second N₂ gas supply source 65 into the chamber 1 to perform post-flow. Then, NH₃ gas is stopped, and N₂ gas is supplied as a purge gas from a purge gas line (not shown) into the chamber 1 to purge the interior of the chamber 1.

One cycle is defined by the steps described above, and is repeated a plurality of times to perform the film formation of the first stage and second stage. Although the number of cycles differs depending on the film formation temperature, the first stage and second stage are repeated one cycle or more, such as 12 to 36 cycles in total. The first stage and second stage may be performed under the same conditions or different conditions. In order to enhance reduction in the first stage, the first step of the first stage is preferably set to be shorter in time than the first step of the second stage, or the second step of the first stage is preferably set to be longer in time than the second step of the second stage

By repeating the steps as described above, a TiN film having a target thickness is formed on a wafer W. The film thickness of this TiN film is set to be, e.g., 5 to 100 nm, and preferably to be 10 to 50 nm.

A gas containing nitrogen atoms or hydrogen atoms may be supplied to slightly nitride the insulating film surface before TiN film formation.

As regards the flow rates of supplied gases, TiCl₄ gas is set to be 5 to 100 mL/min, for example. NH₃ gas is set to be 5 to 100 mL/min in the film formation of the first step, and to be 30 mL/min or more in the post-flow of the second step, for example. N₂ gas for purging is set to be 50 to 5,000 mL/min, and preferably to be 50 to 1,000 mL/min, for example. As described above, at least in the first stage, in order to more sufficiently perform reduction and nitridation of TiCl₄, the flow rate of NH₃ gas is preferably set to be larger in the post-flow than in the film formation. Specifically, the flow rate in the post-flow is preferably set to be 500 mL/min or more, and more preferably to be 5,000 mL/min or more. This condition is preferably applied also to the second stage. The pressure inside the chamber in the film formation is set to be 20 to 800 Pa, for example. The pressure inside the chamber in the NH₃ gas post-flow is set to be 20 to 1,000 Pa, for example.

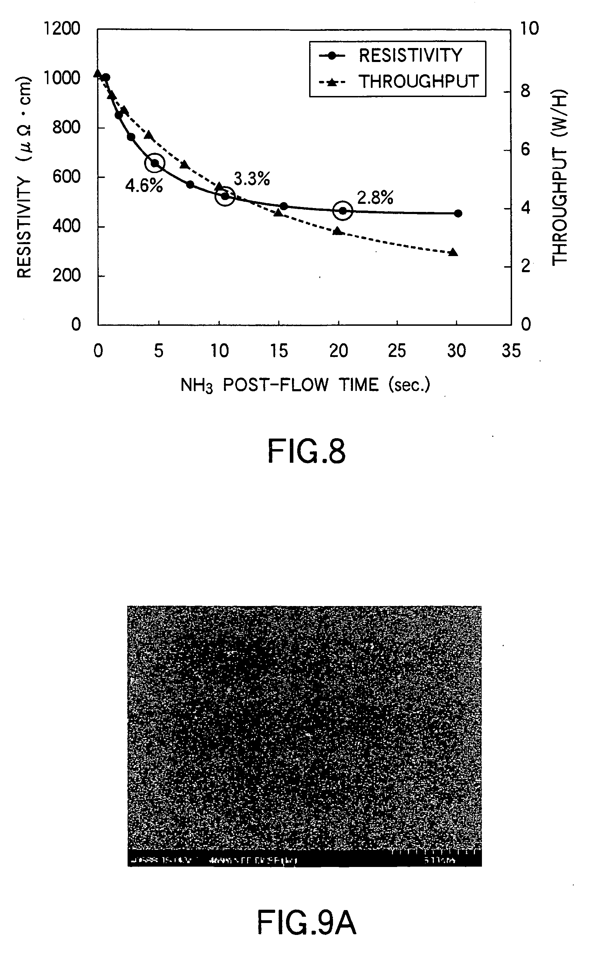

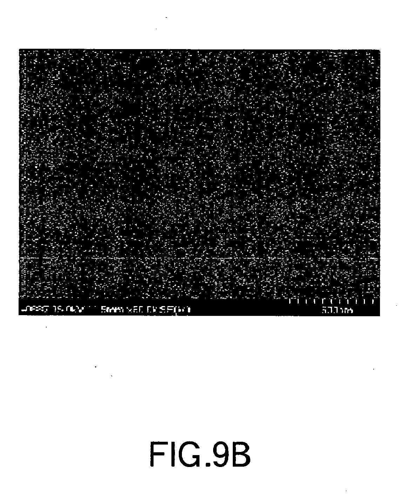

In the TiN film formation, as shown in FIG. 7, the film formation time of the first step is set to be 2 to 8 seconds, the subsequent purge time is set to be 0.5 to 20 seconds, the NH₃ gas post-flow time of the second step is set to be 0.5 to 20 seconds, and the subsequent purge time is set to be 0.5 to 20 seconds, for example. In the case of film formation performed at a low temperature of less than 500°C, the NH₃ gas post-flow time is preferably se to be 2 seconds or more. FIG. 8 is a graph showing the relationship of the NH₃ gas post-flow time of one cycle, which is denoted by the horizontal axis, relative to the resistivity and throughput of a TiN film, which are denoted by the vertical axes. This data was obtained where a TiN film was formed to have a thickness of 16 nm by 36 cycles of the first stage and second stage wherein each cycle accounted for about 0.5 nm, under conditions in which the film formation temperature (wafer temperature) was set at 400°C, the flow rate of TiCl₄ gas was set at 30 mL/min, and the flow rate of NH₃ gas was set at 30 mL/min in the film formation, and at 5,000 mL/min in the post-flow. As shown in FIG. 8, where the post-flow time was 5 seconds, the Cl concentration was high with 4.6%, and the resistivity was thus high due to insufficient reduction. In this case, an abnormal growth was caused as shown in FIG. 9A that shows the surface state at this time. Where the post-flow time was 7 seconds, the resistivity was decreased. Where the post-flow time was 10 seconds, the surface morphology became better as shown in FIG. 9B that shows the surface state at this time. Accordingly, the post-flow time was preferably set to be 7 seconds or more under the conditions described above. However, since the throughput is decreased with an increase in the post-flow time, the time is preferably selected to attain a suitable throughput while preventing abnormal growth.

In the second stage of the TiN film formation, the preferable film thickness of one cycle varies depending on the film formation temperature. Where the film formation temperature is less than 500°C, the film thickness of one cycle is preferably set to be 1.0 nm or less. For example, at 400°C, the film thickness of one cycle is preferably set to be 0.5 nm or less. Conditions corresponding to the film thickness of the second stage are preferably applied also to the first stage.

As described above, the first stage and second stage are arranged to alternately repeat predetermined times a film formation step of supplying both of TiCl₄ gas and NH₃ gas and a post-flow step of solely supplying NH₃ gas, so as to form a TiN film having a predetermined thickness.

The conditions used for the NH₃ gas post-flow also depend on the film thickness of one cycle. Specifically, where the film thickness of one cycle is small, the NH₃ gas post-flow time can be short. With an increase in the NH₃ gas post-flow time, the film thickness of one cycle can be lager.

Specifically, in film formation at 400°C, where the flow rate of NH₃ gas in the post-flow is set at 5,000 mL/min, a film thickness of one cycle of 0.33 nm corresponds to a post-flow time of 4.5 seconds or more, 0.40 nm corresponds to 5.5 seconds or more, 0.5 nm corresponds to 7.0 seconds or more, 0.57 nm corresponds to 8.0 seconds or more, and 0.67 nm corresponds to 11.0 seconds.

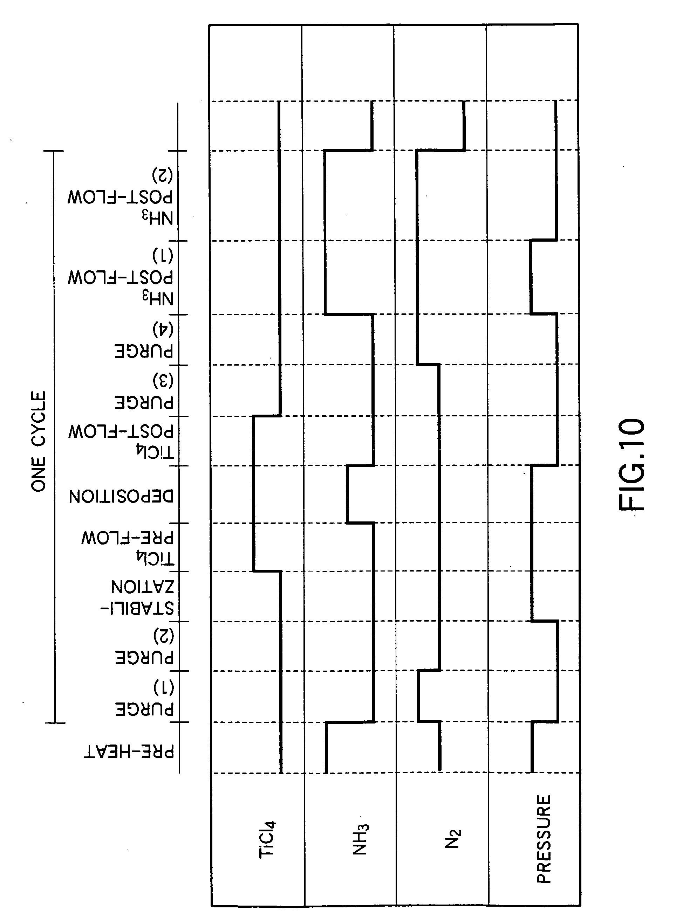

Next, an explanation will be given of an example of an actual sequence for TiN film formation performed at a film formation temperature (wafer temperature) of 400°C. FIG. 10 is a view showing this sequence. At first, N₂ gas is supplied to purge the interior of the chamber. This purging comprises a purge step (1) of first supplying N₂ gas at a total of, e.g., about 1,100 mL/min, and a purge step (2) of then supplying N₂ gas at a decreased flow rate of, e.g., about 200 mL/min, wherein each of the steps is performed for, e.g., 0.5 seconds, resulting in 1 second in total. Then, the pressure inside the chamber is increased to the pressure of the film formation, such as 260 Pa, and is stabilized for, e.g., 1.5 seconds. Then, while the pressure is being maintained, TiCl₄ gas is supplied at a flow rate of, e.g., 30 mL/min to perform TiCl₄ gas pre-flow for, e.g., 0.5 seconds. Then, while the flow rate of TiCl₄ is being maintained, NH₃ gas is supplied at a flow rate of, e.g., 30 mL/min to perform film formation (deposition) for, e.g., 4 seconds. Then, while the flow rate of TiCl₄ is being maintained, NH₃ gas is stopped, the pressure is decreased by exhaust to perform TiCl₄ gas post-flow for, e.g., 0.5 seconds. Then, N₂ gas is supplied for purging. This purging comprises a purge step (3) of first supplying N₂ gas at a total of, e.g., about 200 mL/min, and a purge step (4) of then supplying N₂ gas at an increased flow rate of, e.g., about 1,100 mL/min, wherein each of the steps is performed for, e.g., 0.5 seconds, resulting in 1 second in total. Then, while the flow rate of N₂ gas is being maintained, NH₃ gas post-flow is performed. This NH₃ gas post-flow comprises a NH₃ post-flow step (1) of supplying NH₃ gas at, e.g., 5,000 mL/min while maintaining the pressure at, e.g., 260 Pa, and a NH₃ post-flow step (2) of decreasing the pressure by exhaust while maintaining the gas flow rate, wherein the NH₃ post-flow (1) is performed for, e.g., 10 seconds and the NH₃ post-flow (2) is performed for, e.g., 0.5 seconds.

The cycle described above is repeated 4 times for the film formation of the first stage corresponding to the conventional incubation, and 32 times for the film formation of the second stage, resulting in 36 times in total. Consequently, a TiN film having a thickness of 16 nm is formed with high quality and without abnormal growth. In this case, one cycle of the film formation accounts for a thickness of 0.5 nm.

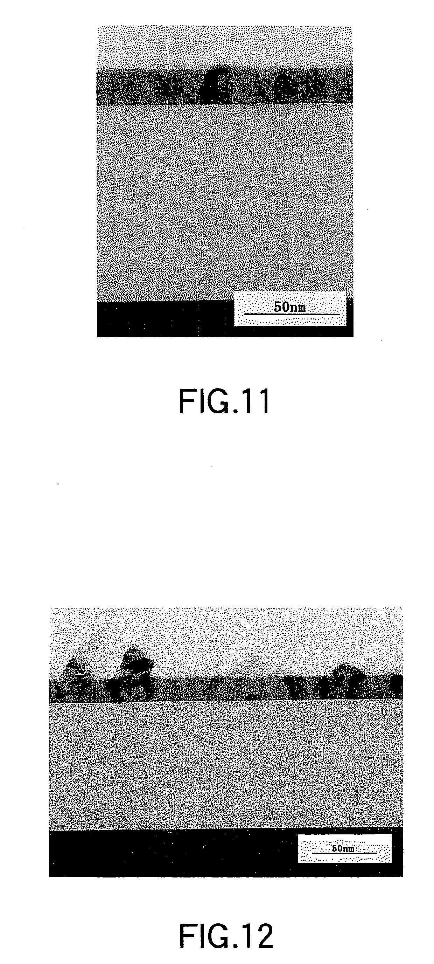

FIG. 11 is a view of a transmission electron microscopy (TEM) photography showing a TiN film actually formed under the conditions described above. As shown in FIG. 11, the TiN surface was smooth. FIG. 12 is a view of a transmission electron microscopy photography showing a TiN film formed by a sequence in which the first 4 cycles of the sequence described above were replaced with an incubation time of 23 seconds along with the flow rates of TiCl₄ gas and NH₃ gas set at 30 mL/min.

After the TiN film formation step described above is finished, a nitridation process may be performed. Specifically, NH₃ gas and TiCl₄ gas are stopped, and N₂ gas is supplied as a purge gas at a flow rate preferably of 0.5 to 10 L/min from each source to purge the interior of the chamber 1. Then, N₂ gas and NH₃ gas are supplied to perform a nitridation process on the surface of the TiN thin film formed on the wafer W. At this time, N₂ gas is supplied from either or both of the first and second N₂ gas supply sources 63 and 65.

As described above, according to this embodiment, the first stage with a low film formation rate at the beginning of film formation is arranged to alternately repeat a film formation step of supplying both of TiCl₄ gas and NH₃ gas and a post-flow step of solely supplying NH₃ gas, as in the steady state, in place of the conventional incubation time. Consequently, a TiN film is formed with high quality and without abnormal growth at a film formation temperature (wafer temperature) of less than 500°C, and particularly of less than 450°C, such as 400°C, which does not allow conventional techniques to sufficiently improve the film surface state.

Accordingly, this embodiment is preferably applicable to a case where a TiN film is formed as an upper electrode on a thermally unstable underlayer made of, e.g., a high dielectric constant material, such as Ta2O5, HfO₂, HfSiO, PZT, BST, RuO₂, or ReO₂, used as a capacitor gate material for DRAM memory sections, or a case where a TiN film is formed as a barrier material on an NiSi film having a low heat resistance.

The film formation described above may be performed at a low temperature of less than 500°C until the middle of the entire thickness of a TiN thin film. In this case, after the film is thus formed up to a thickness that can prevent ill effects from acting on the underlayer, ordinary consecutive CVD-TiN film formation (consecutive film formation) may be sequentially performed at a temperature of 500°C or more, or film formation may be sequentially performed to repeat the cycle shown in FIG. 7. This makes it possible to improve the throughput. In this case, the first film formation step accounts for a film thickness of, e.g., 5 to 50 nm in the TiN film, and the subsequent film formation step accounts for a film thickness of, e.g., 5 to 95 nm in the TiN film.

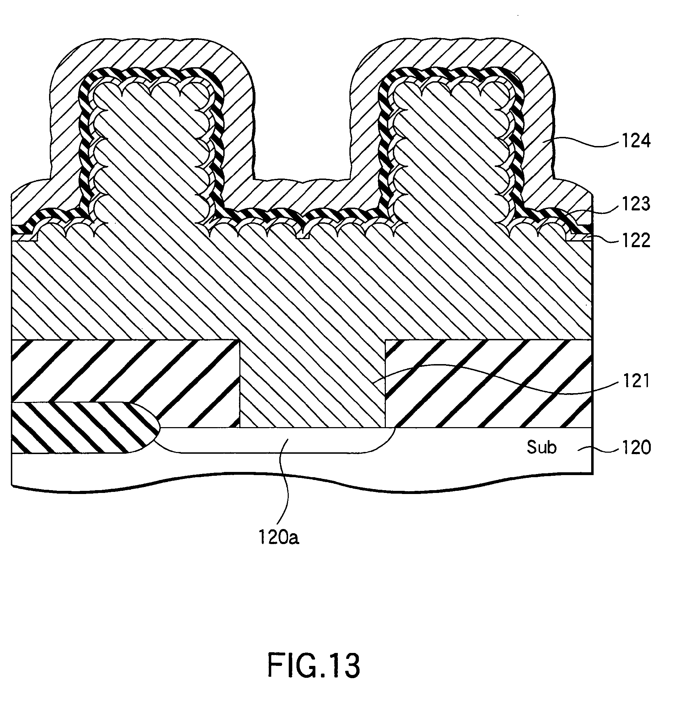

Next, an explanation will be given, with reference to FIG. 13, of an example where a TiN thin film according to the present invention is applied to a capacitor structure, such as a DRAM. In the example shown in FIG. 13, an Si substrate 120 has an impurity diffusion region 120a connected to a lower electrode layer 121 made of HSG (hemispherical grained) poly-crystalline silicon. The lower electrode layer 121 has projected and recessed portions on the surface to increase the surface area (i.e., to increase the charge storage capacity of the capacitor). A very thin SiN barrier layer 122 is formed on the lower electrode layer 121 by an RTN (Rapid Thermal Nitridation) process. A Ta₂O₅ dielectric layer 123 is disposed on the barrier layer 122. Further, an upper electrode layer 124 is disposed on the dielectric layer 123 including the recessed portions. The upper electrode layer 124 is a TiN thin film formed with high coverage by a film formation method according to the present invention. A metal interconnection layer (not shown) is disposed on the upper electrode layer 124.

When the TiN thin film used as the upper electrode layer 124 is formed, the Ta₂O₅ dielectric layer 123 is present as an underlayer, which is thermally unstable and apt to suffer damage. However, according to the present invention, since the TiN film used as the upper electrode layer 124 is formed at a low temperature of less than 450°C, the Ta₂O₅ insulating layer 123 sensitive to heat does not suffer damage. Consequently, it is possible to maintain good capacitance, thereby improving the yield of capacitor portions and further the yield of the memory device as a whole.

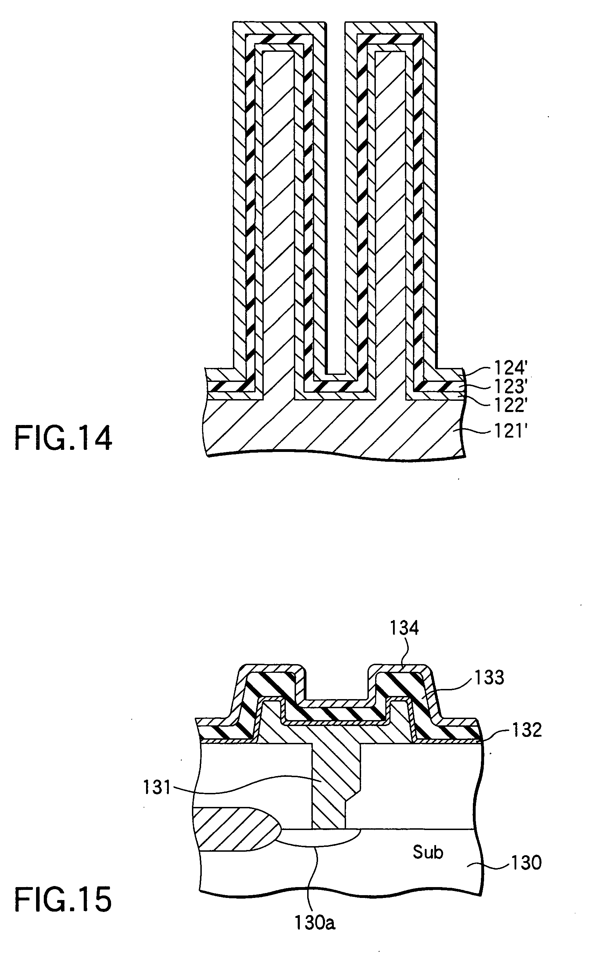

Next, an explanation will be given, with reference to FIG. 14, of an alternative example where a TiN thin film according to the present invention is applied to a capacitor structure, such as a DRAM. In the example shown in FIG. 14, an Si substrate has an impurity diffusion region (not shown) connected to a lower electrode layer 121' made of poly-crystalline silicon. The lower electrode layer 121' has fine shapes with a high aspect ratio to increase the surface area (i.e., to increase the charge storage capacity of the capacitor). Each of the fine shapes of the lower electrode layer 121' is set to have an aspect ratio of 12 or more, and preferably 15 to 100. A very thin SiN barrier layer 122' is formed on the lower electrode layer 121' by an RTN (Rapid Thermal Nitridation) process. A Ta₂O₅ dielectric layer 123' is disposed on the barrier layer 122'. Further, an upper electrode layer 124' is disposed on the dielectric layer 123' including recessed portions. The upper electrode layer 124' is a TiN thin film formed with high coverage by a film formation method according to the present invention. A metal interconnection layer (not shown) is disposed on the upper electrode layer 124'.

Also in this case, since the TiN film used as the upper electrode layer 124' is formed at a low temperature of less than 500°C, the Ta₂O₅ dielectric layer 123' sensitive to heat does not suffer damage. Consequently, it is possible to maintain good capacitance, thereby improving the yield of capacitor portions and further the yield of the memory device as a whole.

Next, an explanation will be given, with reference to FIG. 15, of another alternative example where a TiN thin film according to the present invention is applied to a capacitor structure, such as a DRAM. In the example shown in FIG. 15, an Si substrate 130 has an impurity diffusion region 130a connected to a lower electrode layer 131 made of amorphous Si. A Ta₂O₅ dielectric layer 133 is disposed on the lower electrode layer 131 through an SiN barrier layer 132 formed by subjecting silicon to an RTN (Rapid Thermal Nitridation) process. Further, an upper electrode layer 134, which is a TiN film formed at a low temperature by a film formation method according to the present invention, is disposed on the dielectric layer 133. A metal interconnection layer (not shown) is disposed on the upper electrode layer 134.

Also in this case, since the TiN film used as the upper electrode layer 134 is formed at a low temperature of less than 450°C, the Ta₂O₅ dielectric layer 133 sensitive to heat does not suffer damage. Consequently, it is possible to maintain good capacitance, thereby improving the yield of capacitor portions and further the yield of the memory device as a whole.

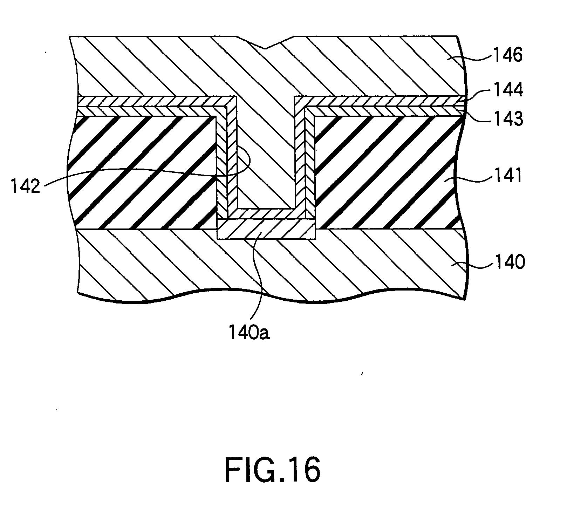

Next, an explanation will be given, with reference to FIG. 16, of an example where a TiN thin film formed by a film formation method according to the present invention is applied to a contact portion of a metal interconnection layer. In the example shown in FIG. 16, an NiSi film 140 is disposed as an interconnection layer or the like on an Si substrate. An inter-level insulating film 141 is disposed on the NiSi film 140 and has an contact hole 142 formed therein to reach the NiSi film 140. A Ti thin film 143 is formed on the inter-level insulating film 141 and in the contact hole 142. At the junction between the Ti thin film 143 and NiSi film 140, a TiSi portion 140a is formed by counter diffusion of Ti and Si respectively diffused from the Ti thin film 143 and NiSi film 140. A TiN thin film 144 is laminated on the Ti thin film 143 by a film formation method according to the present invention performed at a low temperature.

The NiSi film 140 present as an underlayer below the TiN thin film 144 has a low heat resistance and sensitive to heat. However, according to the present invention, since the TiN thin film 144 is formed at a low temperature of less than 500°C, the NiSi film 140 does not suffer thermal damage, thereby providing a good contact.

On this TiN thin film 144, a metal interconnection layer 146 formed of, e.g., Cu or W is further disposed. The metal interconnection layer 146 fills the contact hole 142 so that it is electrically connected to the NiSi film 140 through the TiSi portion 140a. As described above, the TiN thin film 144 can be formed while the low resistivity of the TiSi portion 140a is maintained, so the metal interconnection layer 146 is connected to the NiSi film 140 through the TiSi portion 140a with a good electrical connection. This structure can be applied to a case where the underlayer is a CoSi₂ film.

The present invention is not limited to the embodiment described above, and it may be modified in various manners. For example, in the embodiment described above, the first stage with a low film formation rate at the beginning of film formation is arranged to alternately repeat a film formation step of supplying both of TiCl₄ gas and NH₃ gas and a post-flow step of solely supplying NH₃ gas, in place of the conventional incubation time. However, this is not limiting, as long as reduction of TiCl₄ can be performed without causing local growth. For example, the first stage at the beginning of film formation may be arranged to simply increase NH₃ gas used as a reducing gas, by a predetermined amount. In order to enhance reduction in the first stage, the first stage may employ an ALD method of alternately repeating a step of supplying TiCl₄ gas and a step of supplying NH₃ gas.

In the embodiment described above, the second stage is arranged to alternately repeat a film formation step of supplying both of TiCl₄ gas and NH₃ gas and a post-flow step of solely supplying NH₃ gas, but this is not limiting.

In the embodiment described above, TiCl₄ is used as a Ti-containing compound gas, but another gas, such as an organic Ti compound, may be used. Further, NH₃ is used as a nitrogen-containing reducing gas, but another gas, such as MMH, may be used. In the embodiment described above, the present invention is applied to TiN film formation, but it may be applied to another metal nitride film, such as TaN or WN.

Further, the present invention should be construed to encompass arrangements obtained by suitably combining some of the components of the embodiment described above or excluding some of the components of the embodiment described above, as long as they do not depart from the spirit or scope of the present invention.

### Industrial Applicability

A metal nitride film, such as a TiN film, can be formed at a low temperature by a film formation method according to the present invention. Accordingly, the present invention is preferably applied to a case where the underlayer is low in thermal stability and/or heat resistance, in fabricating an electrode of a capacitor structure, such as a DRAM, or a contact portion of a metal interconnection layer.

## Claims

1. A film formation method comprising:
a first stage including a period of heating a target substrate to a film formation temperature, and supplying a metal compound gas and a nitrogen-containing reducing gas onto the target substrate, thereby directly depositing a metal nitride film by CVD on a target substrate;
a second stage of supplying the metal compound gas and the nitrogen-containing reducing gas, thereby further depositing a metal nitride film by CVD on the metal nitride film initially deposited by the first stage, to obtain a predetermined film thickness,
wherein the first stage is performed under conditions that cause uniform reduction of the metal compound gas to prevent a metal nitride film from being locally deposited.

2. The film formation method according to claim 1, wherein the first stage is arranged to repeat one or more times a cycle comprising a first step of supplying the metal compound gas and the nitrogen-containing reducing gas and a second step of stopping the metal compound gas and supplying the nitrogen-containing reducing gas.

3. The film formation method according to claim 2, wherein the first stage is arranged such that a flow rate of the nitrogen-containing reducing gas in the second step is not smaller than a flow rate of the nitrogen-containing reducing gas in the first step.

4. The film formation method according to claim 1, wherein the metal nitride film is a TiN film.

5. The film formation method according to claim 4, wherein the metal compound gas is TiCl₄ gas, and the nitrogen-containing reducing gas is NH₃ gas.

6. The film formation method according to claim 5, wherein the first stage is arranged such that a flow rate of NH₃ gas in the second step is not smaller than a flow rate of NH₃ gas in the first step.

7. The film formation method according to claim 6, wherein the flow rate of NH₃ gas in the second step is set at 500 mL/min or more.

8. The film formation method according to claim 5, wherein the second step is performed for a time of 2 seconds or more.

9. The film formation method according to claim 1, wherein the film formation temperature of the target substrate is set to be less than 500°C.

10. The film formation method according to claim 1, wherein the second stage is arranged to repeat one or more times a cycle comprising a first step of supplying the metal compound gas and the nitrogen-containing reducing gas and a second step of stopping the metal compound gas and supplying the nitrogen-containing reducing gas.

11. The film formation method according to claim 2, wherein the second stage is arranged to repeat one or more times a cycle comprising a first step of supplying the metal compound gas and the nitrogen-containing reducing gas and a second step of stopping the metal compound gas and supplying the nitrogen-containing reducing gas.

12. The film formation method according to claim 1, wherein the first stage is arranged to repeat one or more times a cycle comprising a third step of supplying the metal compound gas and a fourth step of supplying the nitrogen-containing reducing gas.

13. The film formation method according to claim 12, wherein the second stage is arranged to repeat one or more times a cycle comprising a first step of supplying the metal compound gas and the nitrogen-containing reducing gas and a second step of stopping the metal compound gas and supplying the nitrogen-containing reducing gas.

14. A film formation method comprising:
a first stage including a period of heating a target substrate to a film formation temperature, and supplying a metal compound gas and a nitrogen-containing reducing gas onto the target substrate, thereby directly depositing a metal nitride film by CVD on a target substrate;
a second stage of supplying the metal compound gas and the nitrogen-containing reducing gas, thereby further depositing a metal nitride film by CVD on the metal nitride film initially deposited by the first stage, to obtain a predetermined film thickness,
wherein each of the first stage and the second stage is arranged to repeat one or more times a cycle comprising a first step of supplying the metal compound gas and the nitrogen-containing reducing gas and a second step of stopping the metal compound gas and supplying the nitrogen-containing reducing gas.

15. The film formation method according to claim 14, wherein the first stage and the second stage are arranged to use the same conditions in the first step and the same conditions in the second step.

16. The film formation method according to claim 14, wherein the first step of the first stage is performed for a time shorter than that of the first step of the second stage.

17. The film formation method according to claim 14, wherein the second step of the first stage is performed for a time longer than that of the second step of the second stage.

18. The film formation method according to claim 14, wherein a flow rate of the nitrogen-containing reducing gas in the second step is not smaller than a flow rate of the nitrogen-containing reducing gas in the first step.

19. The film formation method according to claim 14, wherein the metal nitride film is a TiN film.

20. The film formation method according to claim 19, wherein the metal compound gas is TiCl₄ gas, and the nitrogen-containing reducing gas is NH₃ gas.

21. The film formation method according to claim 20, wherein a flow rate of NH₃ gas in the second step is not smaller than a flow rate of NH₃ gas in the first step.

22. The film formation method according to claim 21, wherein the flow rate of NH₃ gas in the second step is set at 500 mL/min or more.

23. The film formation method according to claim 14, wherein the second step is performed for a time of 2 seconds or more.

24. The film formation method according to claim 14, wherein the film formation temperature of the target substrate is set to be less than 500°C.

25. The film formation method according to claim 24, wherein the cycle comprising the first step and the second step is performed under conditions that cause the second stage to provide a thickness of 1 nm or less.

26. A computer readable storage medium that stores a control program for execution on a computer, wherein the control program, when executed by the computer, controls a film formation apparatus to conduct a film formation method comprising:
a first stage including a period of heating a target substrate to a film formation temperature, and supplying a metal compound gas and a nitrogen-containing reducing gas onto the target substrate, thereby directly depositing a metal nitride film by CVD on a target substrate;
a second stage of supplying the metal compound gas and the nitrogen-containing reducing gas, thereby further depositing a metal nitride film by CVD on the metal nitride film initially deposited by the first stage, to obtain a predetermined film thickness,
wherein the first stage is performed under conditions that cause uniform reduction of the metal compound gas to prevent a metal nitride film from being locally deposited.

27. A computer readable storage medium that stores a control program for execution on a computer, wherein the control program, when executed by the computer, controls a film formation apparatus to conduct a film formation method comprising:
a first stage including a period of heating a target substrate to a film formation temperature, and supplying a metal compound gas and a nitrogen-containing reducing gas onto the target substrate, thereby directly depositing a metal nitride film by CVD on a target substrate;
a second stage of supplying the metal compound gas and the nitrogen-containing reducing gas, thereby further depositing a metal nitride film by CVD on the metal nitride film initially deposited by the first stage, to obtain a predetermined film thickness,
wherein each of the first stage and the second stage is arranged to repeat one or more times a cycle comprising a first step of supplying the metal compound gas and the nitrogen-containing reducing gas and a second step of stopping the metal compound gas and supplying the nitrogen-containing reducing gas.
